# EUROPÄISCHE PATENTSCHRIFT

(11) **EP 2 273 857 B1**
(45) Veröffentlichungstag und Bekanntmachung des Hinweises auf die Patenterteilung: **30.03.2016**
(21) Anmeldenummer: 10450105.1
(22) Anmeldetag: 22.06.2010
(51) Int. Cl.: H05K 3/00, B28B 11/00

(54) **Vorrichtung zum Formen oder Bearbeiten von Werkstücken**
Device for forming or machining workpieces
Dispositif destiné au formage ou au traitement de pièces à usiner

(30) Priorität: 22.06.2009 AT 9622009
(43) Veröffentlichungstag der Anmeldung: 12.01.2011
(73) Patentinhaber: Semlitsch, Karl-Heinz, 8680 Mürzzuschlag (AT); Zöttl, Andreas, 2491 Steinbrunn-Neue Siedlung (AT)
(72) Erfinder: Semlitsch, Karl-Heinz, 8680 Mürzzuschlag (AT); Zöttl, Andreas, 2491 Steinbrunn-Neue Siedlung (AT)
(74) Vertreter: Wildhack & Jellinek

(56) Entgegenhaltungen:
- DE-A1- 10 300 831
- DE-C1- 4 119 624
- DE-U1- 8 714 959
- DE-U1- 9 001 862
- GB-A- 1 305 712
- US-A- 5 733 081

## Beschreibung

Die Erfindung betrifft eine Vorrichtung zum Bearbeiten von Gegenständen gemäß dem Oberbegriff des Anspruchs 1.

Erfindungsgemäße Vorrichtungen werden insbesondere zur Fertigung von perforierten Folien gewerblich angewendet.

Herkömmliche Bearbeitungsvorrichtungen wie z.B. Stanzvorrichtungen sind zur Gänze aus Metall aufgebaut, sie bestehen insbesondere aus Aluminium, Stahl oder Grauguss. Bei der Herstellung von gestanzten bzw. perforierten Folien ist es erforderlich, äußerst geringe Toleranzen, etwa im Bereich von 0,001 mm, einzuhalten. Eine derartige Anforderung tritt beispielsweise auch bei der Herstellung bzw. Lochung von gedruckten Leiterplatten auf. Bei sehr hohen Stanzgeschwindigkeiten von etwa 10 bis 50 Hüben pro Sekunde ist die gesamte Stanzvorrichtung, insbesondere die Stanzwerkzeuge sowie das die Stanzwerkzeuge tragende Bearbeitungsmodul, nicht unerheblichen thermischen Ausdehnungen ausgesetzt. Dies wiederum führt dazu, dass aufgrund der thermischen Ausdehnungen die Stanzwerkzeuge einen seitlichen Versatz gegenüber ihrer Grundposition erfahren und die gestanzten Gegenstände bzw. Folien nach der Erwärmung der Stanzvorrichtung ein abweichendes Stanzmuster aufweisen.

In der Veröffentlichung DE 41 19 624 C1 ist eine Vorrichtung zum kraft- und/oder formschlüssigen Fügen von Blechen beschrieben. Diese umfasst eine aus einem Stempel und einer Matrize bestehenden Fügeeinheit, wobei der Stempel über eine Betätigungseinreichung in Richtung auf und gegen die Matrize beaufschlagbar und von dieser lösbar angeordnet ist. Die Matrize ist in einer Aufnahme koaxial zur Bewegungsrichtung des Stempels verschiebbar positioniert und an ihrem, dem Stempel abgewandten Ende auf einem Schwenklager mit einer im wesentlichen senkrecht zur Bewegungsrichtung des Stempels verlaufenden Schwenkachse geführt.

Aus diesem Grund ist der Aufbau größerer Vorrichtungen, die Gegenstände mit Oberflächen von mehr als 10 cm² Ausdehnung bearbeiten können, nicht möglich. Bei typischen Anlagen gemäß dem Stand der Technik wird so vorgegangen, dass für einzelne Teilbereiche bzw. Bearbeitungsprozesse ein eigenes Werkzeug verwendet wird und eine Vielzahl von Werkzeugen in einen großen gemeinsamen Werkzeugrahmen eingebaut wird. Es kann jedoch aufgrund der thermischen Ausdehnung weiterhin zu Bearbeitungs- oder Vorschubfehlern kommen.

Zusätzlich besteht bei großen Werkzeugrahmen mit mehreren eingebauten Bearbeitungsmodulen oder Werkzeugträgern das Problem, dass der Werkzeugrahmen aufgrund seiner Ausdehnung und Beschaffenheit durch die Hubbewegungen in seiner Eigenschwingung angeregt wird und zusätzlichen schwingungsbedingten mechanischen Belastungen ausgesetzt ist, welche die Lebenszeit der Standzeit deutlich herabsetzen.

Die Aufgabe der Erfindung liegt darin, eine Vorrichtung zur Verfügung zu stellen, welche die eingangs beschriebenen Nachteile vermeidet. Speziell ist die Aufgabe der Erfindung darauf gerichtet, die Lebensdauer einer solchen Vorrichtung zu erhöhen, insbesondere die Schwingungsanfälligkeit und die Anfälligkeit gegenüber thermischen Effekten zu verringern.

Erfindungsgemäß werden diese Nachteile bei einer Vorrichtung zum Formen oder Bearbeiten von Werkstücken, insbesondere zum Stanzen von Folien, mit einem Grundgestell sowie einem gegenüber diesem Grundgestell entlang eines, vorzugsweise linearen, Wegs verschiebbar gelagerten Werkzeugs zur Bearbeitung des Werkstücks dadurch überwunden, dass das Grundgestell zumindest teilweise aus faserverstärktem Kunststoff bzw. Faserverbundkunststoff besteht.

Hierdurch ergibt sich der erhebliche Vorteil, dass die gesamte Vorrichtung ein geringeres Gewicht aufweist und insbesondere weniger Energie zum Betrieb der Bearbeitungsvorrichtung benötigt wird. Ferner werden aufgrund des verwendeten Materials resonanzbedingte Durchbiegungen bei großen Spannweiten von Bearbeitungsmodulen vermieden. Aufgrund der beinahe verschwindenden Wärmeausdehnung des verwendeten Materials ist die Form der bearbeiteten Gegenstände unabhängig von der Temperatur. Ferner wird erfindungsgemäß eine erhöhte Materialabnutzung vermieden, da die Bearbeitungsvorrichtungen auch bei hohen Hubzahlen keinen mechanischen Schwingungen und keinen Resonanzphänomenen unterliegen. Selbst bei Temperaturerhöhungen, die aufgrund des Bearbeitungsprozesses unweigerlich als Reibungsabwärme auftreten, kann eine gleichmäßige Schnittspalte von weniger als 0,0015 mm pro Seite eingehalten werden.

Durch die Vermeidung von mechanischen Spannungen, die von Schwingungen sowie von thermischer Ausdehnung herrühren, wird die Lebensdauer sämtlicher Komponenten der Vorrichtung, insbesondere der Werkzeuge, erzielt.

Die Erfindung sieht vor, dass das Bearbeitungsmodul zumindest teilweise aus faserverstärktem Kunststoff bzw. Faserverbundkunststoff besteht.

Dies verbessert das Verhalten der erfindungsgemäßen Vorrichtung bei thermischen Einwirkungen. Weiters wird die Anfälligkeit gegenüber Schwingungen verbessert.

Weiters sieht die Erfindung vor, dass das Bearbeitungsmodul jeweils zumindest eine massive Platte aus Faserverbundkunststoff aufweist.

Dies verbessert die mechanische Stabilität und verringert die mechanischen Schwingungen im Grundgestell und im Bearbeitungsmodul.

Ferner sieht die Erfindung vor, dass jede Platte des Grundgestells oder das Grundgestell aus mehreren flächig, insbesondere in Sandwich-Bauweise, miteinander verbundenen plattenförmigen Elementen aufgebaut ist.

Dies verbessert die mechanische Stabilität und verringert die im Material auftretenden Schwingungen.

Weitere vorteilhafte Ausgestaltungen und Aspekte der Erfindung werden in den Unteransprüchen beschrieben.

Ein bevorzugter Aspekt der Erfindung besteht darin, dass die Vorrichtung ein Bearbeitungsmodul aufweist, welches das Werkzeug trägt, und entlang eines, vorzugsweise linearen, Wegs verschiebbar gelagert ist.

Mit dieser bevorzugten Weiterbildung der Erfindung wird der Aufbau von Press- und Stanzvorrichtungen ermöglicht, bei der eine Vielzahl von Werkzeugen gemeinsam betätigt werden kann. Dabei ist von Vorteil, dass auf Grund der geringen thermischen Verbiegungen und Ausdehnungen die relative Positionierung der Werkzeuge nur geringen Schwankungen unterliegt.

Ein weiterer bevorzugter Aspekt der Erfindung besteht darin, dass der Weg, entlang dessen das Bearbeitungsmodul gelagert ist, in Arbeitsstellung waagrecht bzw. horizontal angeordnet ist.

Auf Grund des geringen Eigengewichts sowie der hohen Biegesteifigkeit und Schwingungsdämpfung der erfindungsgemäßen Komponenten wird eine Verbiegung der Materialien weitestgehend verhindert. Die Relativbewegung zwischen dem Grundgestell bzw. den Führungssäulen und dem Bearbeitungsmodul ist somit auch bei einer in Arbeitsstellung waagrechten Stanzrichtung ohne Einschränkungen möglich.

Besonders vorteilhaft bei einer derartigen Vorrichtung ist, dass der im Zuge des Stanzens entstehende Abfall durch die Schwerkraft von selbst nach unten fällt und ein zusätzlicher Schritt des Beseitigens von Stanzabfällen entfallen kann.

Ein besonders vorteilhafter Aspekt der Erfindung besteht darin, dass das Grundgestell C-förmig ausgebildet ist und aus Kunststoff bzw. Faserverbundkunststoff besteht, wobei im Grundgestell zumindest eine Ausnehmung vorgesehen ist, die von dem Werkzeug durchsetzt ist, das in dieser Ausnehmung entlang des Wegs verschiebbar ist und ein Ende des Wegs im Innenbereich des C-förmigen Grundgestells liegt.

In diesem Fall wirken große Schwingungskräfte auf das Grundgestell ein, was bei einem Aufbau der erfindungsgemäßen Vorrichtung mit konventionellen Werkstoffen zu massiven Schwingungen führen würde. Bei Verwendung eines erfindungsgemäßen Faserverbundkunststoffs werden derartige Schwingungen wirksam verhindert.

Ein weiterer Aspekt der Erfindung ist dadurch gekennzeichnet, dass das Bearbeitungsmodul und/oder das Grundgestell zur Gänze aus faserverstärktem Kunststoff bzw. Faserverbundkunststoff bestehen.

Dies verringert zum einen mechanische Schwingungen im Grundgestell, was eine zusätzliche Energieersparnis bietet. Weiters kann das Gewicht der erfindungsgemäßen Bearbeitungsvorrichtung hierdurch weiter reduziert werden.

Ein bevorzugter Aspekt der Erfindung besteht darin, dass die Platte des Bearbeitungsmoduls zur Platte des Grundgestells parallel ausgerichtet ist.

Dies ermöglicht ein besonders effizientes Bearbeiten und verringert den für die Materialbearbeitung benötigten Hub. Zudem kann eine Lagerung des Bearbeitungsmoduls gegenüber dem Grundgestell leichter bewerkstelligt werden.

Ein weiterer Aspekt der Erfindung besteht darin, dass der zur Bildung der Faserverbundkunststoff eine thermoplastische oder eine duroplastische Matrix, vorzugsweise aus Epoxidharz, besitzt.

Diese Materialien eignen sich besonders gut zur Unterdrückung von Schwingungen und geben den Werkzeugen die erforderliche innere Stabilität während des Bearbeitungsvorgangs.

Ein zusätzlicher bevorzugter Aspekt der Erfindung besteht darin, dass der Faserverbundkunststoff anorganische Verstärkungsfasern und/oder organische Verstärkungsfasern, insbesondere Kohlestofffasern bzw. Karbonfasern, enthält.

Diese Fasern verbessern die innere Stabilität des Bearbeitungsmoduls und verringern den Werkzeugverschleiß durch die Reduktion der inneren Schwingungen der Werkzeuge.

Erfindungsgemäße Vorrichtungen kennzeichnen sich bevorzugterweise dadurch, dass die Fasern in Form von Rovings, Matten, Geweben oder Gelegen vorliegen.

Dies sorgt für die nötige innere Stabilität und verbessert das Schwingungsverhalten des Bearbeitungsmoduls und des Grundgestells.

Ein bevorzugter Aspekt der Erfindung ist dadurch gekennzeichnet, dass der Faserverbundkunststoff ein kohlenstofffaserverstärkter Kunststoff ist, wobei die Fasern, vorzugsweise in mehreren Lagen, in die Kunststoffmatrix eingebettet sind und wobei das Elastizitätsmodul der Fasern höher ist, als das Elastizitätsmodul der Kunststoffmatrix.

Dies bietet eine besonders hohe Steifigkeit und unterdrückt mechanische Schwingungen, die durch die Bewegungen des Bearbeitungsmoduls angeregt werden.

Eine bevorzugte Ausführungsform der Erfindung kennzeichnet sich dadurch, dass der Faserverbundkunststoff Kurzfasern mit einer Länge zwischen 0,1 bis 1 mm und/oder Langfasern mit einer Länge von etwa 80% bis 150% der maximalen Abmessung des Grundgestells bzw. des Bearbeitungsmoduls.

Kunststoffe mit Fasern dieser Länge eignen sich besonders gut für die Unterdrückung von inneren Materialschwingungen.

Weiters betrifft die Erfindung den vorteilhaften Aspekt, dass der Faserverbundkunststoff einen Fasergehalt von 40 bis 80 Gew% aufweist.

Dies ermöglicht eine sehr hohe Materialsteifigkeit, die sich vorteilhaft auf das Schwingungsverhalten der Vorrichtung, insbesondere des Bearbeitungsmoduls auswirkt.

Ein bevorzugter Aspekt der Erfindung sieht vor, dass das Bearbeitungsmodul Ausnehmungen aufweist, in die Werkzeuge eingebracht sind.

Dies ermöglicht die Verwendung einer Vielzahl unterschiedlicher Werkzeuge und verringert die Übertragung von Schwingungen auf das Bearbeitungsmodul. Durch die Gewichtsreduktion des Bearbeitungsmoduls durch die Verwendung von Platten kann mit demselben Energieaufwand eine höhere Taktzahl an Hubbewegungen erreicht werden.

Ein weiterer vorteilhafter Aspekt dieser Erfindung liegt darin, dass erfindungsgemäße Vorrichtung Werkzeuge zum Stanzen, Biegen, Prägen, Nieten oder Pressen aufweist.

Durch die schwingungsarme Ausführung kann eine Vielzahl von unterschiedlichen Werkzeugen mit geringem Verschleiß und hoher Präzision betrieben werden.

Die Erfindung wird anhand von drei Beispielen in den folgenden Figuren exemplarisch und nicht einschränkend dargestellt.
**Fig. 1** zeigt den Aufbau einer erfindungsgemäßen Stanzvorrichtung.
**Fig. 2** zeigt den Aufbau einer erfindungsgemäßen Stanzvorrichtung mit waagrechter Verschiebung des Werkzeugs.
**Fig. 3** zeigt den Aufbau einer alternativen Ausführungsform der Erfindung mit C-förmigem Grundgestell.

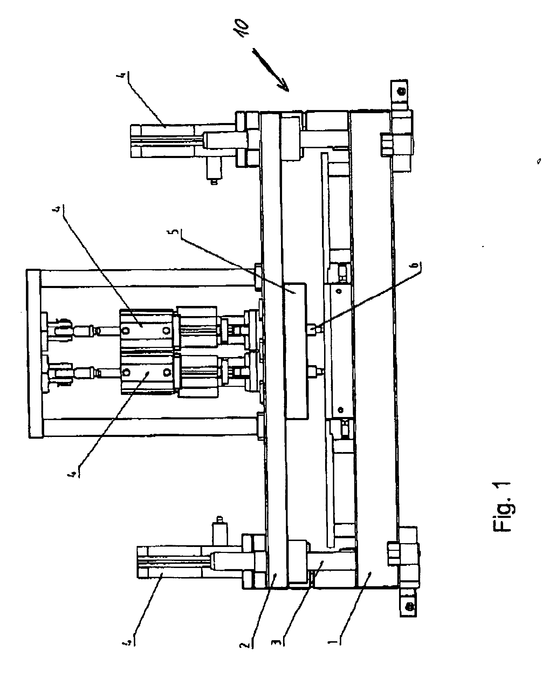

Eine erste Ausführungsform der Erfindung, dargestellt in Fig. 1, umfasst ein Grundgestell, das mit einer Platte 1 gebildet ist. An ihrer Unterseite weist die Platte 1 eine Befestigungsvorrichtung zum Befestigen an einem Grundgestell auf. Die Platte 1 besteht aus einer Anzahl von miteinander flächig verklebten flachen Plattenelementen, die in Sandwich-Bauweise zusammengefügt sind. An ihrer Oberseite weist die Platte 1 vier Löcher auf, die von Führungssäulen 3 durchsetzt sind. Auf jeder Seite der Platte 1 sind jeweils zwei Führungssäulen 3 angeordnet. Im Zwischenbereich zwischen den Führungssäulen 3 befinden sich Führungs- und Halterungsteile für die zu stanzenden Gegenstände bzw. für eine Folie. Gegenüber dem Grundgestell ist ein Bearbeitungsmodul 2 entlang eines linearen Wegs parallel verschiebbar gelagert. Dieses Bearbeitungsmodul 2 umfasst eine weitere Platte, die vier durchgängige Ausnehmungen aufweist, die von jeweils einer der Führungssäulen 3 durchsetzt sind. An der Unterseite des Bearbeitungsmoduls 2 ist eine Halterung 5 für Werkzeuge 6 angeordnet. Diese Halterung 5 ist mit dem Bearbeitungsmodul 2 verschraubt bzw. sind das Bearbeitungsmodul 2 und die Halterung 5 aus einem einzigen Formteil gebildet. An der Unterseite bzw. an der der Platte 1 des Gestells zugewandten Seite des Bearbeitungsmoduls 2 ist eine Anzahl von Werkzeugen 6 angeordnet.

Der Antrieb der erfindungsgemäßen Vorrichtung erfolgt mittels Zylinder 4, die im Mittelbereich des Bearbeitungsmoduls 2 sowie im Bereich der Führungsstangen 3 angeordnet sind. Werden die Zylinder 4 gleichzeitig mit Druckluft oder Hydrauliköl beaufschlagt, wird das Bearbeitungsmodul 2, die Halterung 5 für die Werkzeuge 6 sowie die einzelnen Werkzeuge 6 entlang eines parallel zur Ausdehnungsrichtung der Führungssäulen 3 verlaufenden linearen Wegs verschoben und die Werkzeuge 6 stanzen eine Ausnehmung in den zu bearbeitenden Gegenstand. Die Platte des Bearbeitungsmoduls 2 ist dabei parallel zur Platte des Grundgestells.

In einer besonders bevorzugten Ausführungsform der Erfindung ist vorgesehen, dass der für die Ausbildung der Platten des Bearbeitungsmoduls 2 und des Grundgestells verwendete Faserverbundkunststoff einen Fasergehalt von 40 Gew% bis 80 Gew% aufweist und ein duroplastisches oder thermoplastisches Matrixsystem aufweist. Der erfindungsgemäße Effekt kann bei einem Faserverbundkunststoff mit Rovings, mit Gelegen oder mit Geweben erreicht werden.

In diesem Beispiel wird ein duroplastisches Matrixsystem, nämlich Epoxidharz, verwendet, das ein Carbongewebe mit quasiisotropem Aufbau enthält, wobei der so gebildete Faserverbundkunststoff einen Fasergehalt von 56 Gew% aufweist. Im vorliegenden Fall misst die Raumdiagonale dieser Platte 1 etwa 75cm.

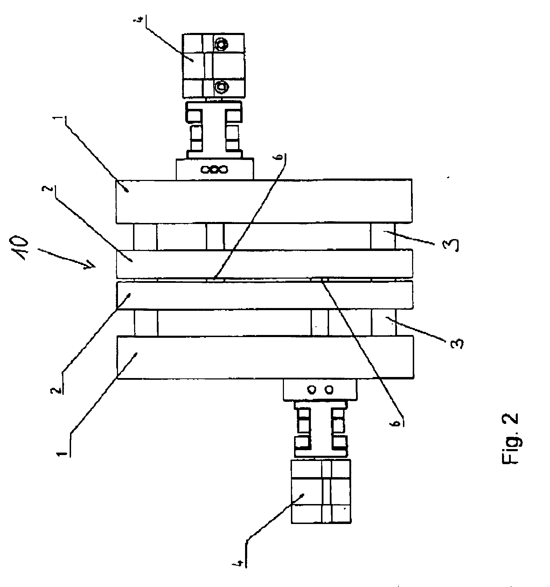

Eine weitere Ausführungsform der Erfindung (Fig. 2) entspricht der in Fig. 1 dargestellten Ausführungsform mit dem Unterschied, dass die Stanzbewegungen in horizontaler oder waagrechter Richtung ausgeführt werden. Mit den Mitteln des Standes der Technik, insbesondere bei der Verwendung von Stahl oder Aluminium als Trägermaterial des Grundgestells oder des Bearbeitungsmoduls 2, ist eine Stanzbewegung in waagrechter Richtung auf Grund des großen Eigengewichts der mechanischen Komponenten nicht möglich. Durch das Eigengewicht der mechanischen Komponenten werden die Führungssäulen 3 bzw. das Grundgestell und das Bearbeitungsmodul 2 geringfügig gebogen, was die Leichtgängigkeit der Verschiebung verringert. Zusätzlich wird durch die thermische Ausdehnung des Materials eine mechanische Spannung induziert, welche die Verschiebung des Bearbeitungsmoduls 2 gegenüber dem Grundgestell bzw. den Führungssäulen weiter erschwert.

Auf Grund des geringen Eigengewichts sowie der hohen Biegesteifigkeit und Schwingungsdämpfung der erfindungsgemäßen Komponenten wird eine Verbiegung der Materialien weitestgehend verhindert. Die Relativbewegung zwischen dem Grundgestell bzw. den Führungssäulen und dem Bearbeitungsmodul 2 ist somit auch bei einer waagrechten Stanzrichtung ohne Einschränkungen möglich.

Besonders vorteilhaft bei einer derartigen Vorrichtung ist, dass der im Zuge des Stanzens entstehende Abfall durch die Schwerkraft von selbst nach unten fällt und ein zusätzlicher Schritt des Beseitigens von Stanzabfällen entfallen kann.

Im diesem Beispiel wird ein duroplastisches Matrixsystem, nämlich Epoxidharz, verwendet, das ein Carbongewebe mit quasiisotropem Aufbau enthält, wobei der so gebildete Faserverbundkunststoff einen Fasergehalt von 56 Gew% aufweist. Im vorliegenden Fall misst die Raumdiagonale dieser Platte 1 etwa 60cm.

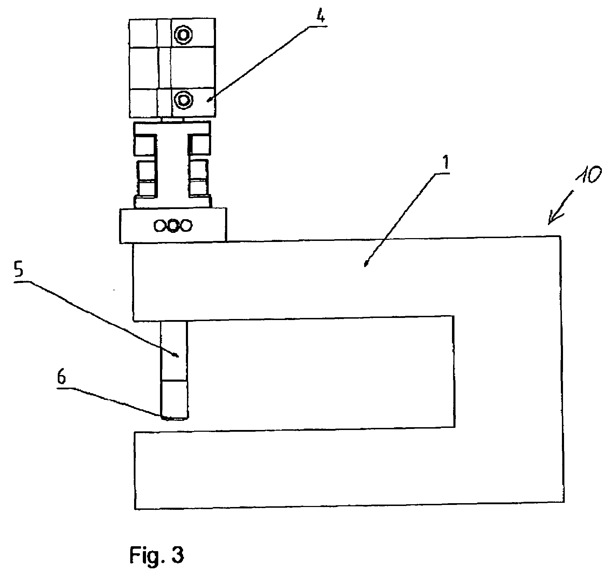

Eine dritte Ausführungsform, die in **Fig. 3** dargestellt ist, sieht ein C-förmiges Grundgestell aus Faserverbundwerkstoff vor. In diese Struktur kann das zu bearbeitende Werkstück von der Seite eingebracht werden und mit einer Positionierungseinrichtung, beispielsweise einem Roboter, positioniert werden. In diesem Fall sind die Werkzeuge nicht fest mit der Struktur verbunden, sondern durchsetzen eine Ausnehmung im oberen Bereich des Grundgestells 2. Die Werkzeuge 6 werden von einem hydraulischen oder pneumatischen Zylinder 4 angetrieben, durch die Ausnehmung des Grundgestells hindurchbewegt und wirken auf das zu bearbeitende Werkstück ein.

Im diesem Beispiel wird ein duroplastisches Matrixsystem, nämlich Epoxidharz, verwendet, das ein Carbongewebe mit quasiisotropem Aufbau enthält, wobei der so gebildete Faserverbundkunststoff einen Fasergehalt von 56 Gew% aufweist. Im vorliegenden Fall betragen die Abmessungen des Grundgestells etwa 50cm.

## Patentansprüche

1. Vorrichtung zum Formen oder Bearbeiten von Werkstücken, insbesondere zum Stanzen von Folien, mit einem Grundgestell sowie einem gegenüber diesem Grundgestell entlang eines, vorzugsweise linearen, Wegs verschiebbar gelagerten Werkzeugs (6) zur Bearbeitung des Werkstücks, *wobei* das Grundgestell zumindest teilweise aus faserverstärktem Kunststoff *und*/*oder* Faserverbundkunststoff besteht, ***dadurch gekennzeichnet, dass** das Grundgestell jeweils zumindest eine massive Platte (1) aus Faserverbundkunststoff aufweist, und dass jede Platte (1) des Grundgestells oder das Grundgestell aus mehreren flächig, insbesondere in Sandwich-Bauweise, miteinander verbundenen plattenförmigen Elementen aufgebaut ist.*

2. Vorrichtung nach Anspruch 1, **dadurch gekennzeichnet, dass** die Vorrichtung ein Bearbeitungsmodul (2) aufweist, welches das Werkzeug (6) trägt, und entlang eines, vorzugsweise linearen, Wegs verschiebbar gelagert ist.

3. Vorrichtung nach Anspruch 2, **dadurch gekennzeichnet, dass** der Weg, entlang dessen das Bearbeitungsmodul (2) verschiebbar gelagert ist, in Arbeitsstellung waagrecht bzw. horizontal angeordnet ist.

4. Vorrichtung nach Anspruch 1, **dadurch gekennzeichnet, dass** das Grundgestell C-förmig ausgebildet ist und aus Kunststoff bzw. Faserverbundkunststoff besteht, wobei im Grundgestell zumindest eine Ausnehmung vorgesehen ist, die von dem Werkzeug (6) durchsetzt ist, das in dieser Ausnehmung entlang des Wegs verschiebbar ist und ein Ende des Wegs im Innenbereich des C-förmigen Grundgestells liegt.

5. Vorrichtung nach einem der vorangehenden Ansprüche, **dadurch gekennzeichnet, dass** das Bearbeitungsmodul (2) zumindest teilweise aus faserverstärktem Kunststoff bzw. Faserverbundkunststoff besteht.

6. Vorrichtung nach einem der vorangehenden Ansprüche, **dadurch gekennzeichnet, dass** das Bearbeitungsmodul (2) und/oder das Grundgestell zur Gänze aus faserverstärktem Kunststoff bzw. Faserverbundkunststoff bestehen.

7. Vorrichtung nach einem der vorangehenden Ansprüche, **dadurch gekennzeichnet, dass** das Bearbeitungsmodul (2) jeweils zumindest eine massive Platte (1) aus Faserverbundkunststoff *aufweist.*

8. Vorrichtung nach Anspruch 7, **dadurch gekennzeichnet, dass** die Platte des Bearbeitungsmoduls (2) zur Platte (1) des Grundgestells parallel ausgerichtet ist.

9. Vorrichtung nach Anspruch 7 oder 8, **dadurch gekennzeichnet, dass** jede Platte (1) *und*/*oder* das Bearbeitungsmodul (2) aus mehreren flächig, insbesondere in Sandwich-Bauweise, miteinander verbundenen plattenförmigen Elementen aufgebaut ist.

10. Vorrichtung nach einem der vorangehenden Ansprüche, **dadurch gekennzeichnet, dass** der Faserverbundkunststoff eine thermoplastische oder eine duroplastische Matrix, vorzugsweise aus Epoxydharz, besitzt.

11. Vorrichtung nach einem der vorangehenden Ansprüche, **dadurch gekennzeichnet, dass** der Faserverbundkunststoff anorganische Verstärkungsfasern und/oder organische Verstärkungsfasern, insbesondere Kohlestofffasern bzw. Karbonfasern, enthält.

12. Vorrichtung nach einem der vorangehenden Ansprüche, **dadurch gekennzeichnet, dass** die Fasern in Form von Rovings, Kurzfasern, Matten, Geweben oder Gelegen vorliegen.

13. Vorrichtung nach einem der vorangehenden Ansprüche, **dadurch gekennzeichnet, dass** der Faserverbundkunststoff ein kohlenstofffaserverstärkter Kunststoff ist, wobei die Fasern, vorzugsweise in mehreren Lagen, in die Kunststoffmatrix eingebettet sind und wobei das Elastizitätsmodul der Fasern höher ist, als das Elastizitätsmodul der Kunststoffmatrix.

14. Vorrichtung nach einem der vorangehenden Ansprüche, **dadurch gekennzeichnet, dass** der Faserverbundkunststoff Kurzfasern mit einer Länge zwischen 0,1 bis 5 mm und/oder Langfasern mit einer Länge zwischen 80% und 150% der maximalen Abmessung des Grundgestells bzw. des Bearbeitungsmoduls und/oder Endlosfasern enthält und/oder, dass der Faserverbundkunststoff einen Fasergehalt von 40 bis 80 Gew% aufweist.

15. Vorrichtung nach einem der vorangehenden Ansprüche, **dadurch gekennzeichnet, dass** das Bearbeitungsmodul (2) eine Anzahl von Ausnehmungen aufweist, in welche die Werkzeuge (6) eingebracht sind und/oder, dass die Vorrichtung Werkzeuge zum Stanzen, Biegen, Prägen, Nieten oder Pressen aufweist.

## Claims

1. Device for forming or processing workpieces, in particular for punching sheets, comprising a base frame as well as a tool (6) opposite this base frame that is mounted to slide along a preferably linear path for processing the workpiece, wherein the base frame is at least partially made of fibre-reinforced plastic and/or fibre composite plastic, **characterised in that** the base frame comprises at least one solid plate (1) made of fibre composite plastic, and **in that** each plate (1) of the base frame, or the base frame, is constructed from several flat interconnected plate-like elements, in particular having a sandwich construction.

2. Device according to claim 1, **characterised in that** the device has a processing module (2) which carries the tool (6), and is mounted to be displaced along a preferably linear path.

3. Device according to claim 2, **characterised in that** the path along which the processing module (2) is mounted to be displaced, is arranged to be level or horizontal in the working position.

4. Device according to claim 1, **characterised in that** the base frame is C-shaped and is made of plastic or fibre composite plastic, wherein at least one recess is provided in the base frame through which the tool (6) passes and is displaced along the path, wherein an end of the path lies in the inner region of the C-shaped base frame.

5. Device according to one of the preceding claims, **characterised in that** the processing module (2) consists at least partially of fibre-reinforced plastic or fibre composite plastic.

6. Device according to one of the preceding claims, **characterised in that** the processing module (2) and/or the base frame consist in their entirety of fibre-reinforced plastic or fibre composite plastic.

7. Device according to one of the preceding claims, **characterised in that** the processing module (2) has at least one solid plate (1) made of fibre composite plastic.

8. Device according to claim 7, **characterised in that** the plate of the processing module (2) is aligned in parallel to the plate (1) of the base frame.

9. Device according to claim 7 or 8, **characterised in that** each plate (1) and/or the processing module (2) is constructed from several flat interconnected plate-shaped elements, in particular having a sandwich construction.

10. Device according to one of the preceding claims, **characterised in that** the fibre composite plastic comprises a thermoplastic or thermosetting matrix, preferably of epoxy resin.

11. Device according to one of the preceding claims, **characterised in that** the fibre composite plastic contains inorganic reinforcing fibres and/or organic reinforcing fibres, especially carbon fibres.

12. Device according to one of the preceding claims, **characterised in that** the fibres are present in the form of rovings, short fibres, mats, fabrics or nonwovens.

13. Device according to one of the preceding claims, **characterised in that** the fibre composite plastic is a carbon fibre reinforced plastic, wherein the fibres are preferably embedded in the plastic matrix in a plurality of layers, and wherein the modulus of elasticity of the fibres is higher than the modulus of elasticity of the plastic matrix.

14. Device according to one of the preceding claims, **characterised in that** the fibre composite plastic contains short fibres having a length between 0.1 and 5 mm and/or long fibres having a length between 80% and 150% of the maximum dimension of the base frame or the processing module and/or contains continuous fibres and/or **in that** the fibre composite plastic has a fibre content of 40 to 80% by weight.

15. Device according to one of the preceding claims, **characterised in that** the processing module (2) comprises a number of recesses into which the tools (6) are introduced and/or that the device has tools for punching, bending, stamping, riveting or pressing.

## Revendications

1. Dispositif de formage ou d'usinage de pièce, plus particulièrement pour le poinçonnage de feuilles, avec un châssis de base ainsi qu'un outil (6) logé de manière coulissante par rapport à ce châssis de base le long d'un trajet, de préférence linéaire, pour l'usinage de la pièce, le châssis de base étant constitué au moins partiellement d'une matière plastique renforcée avec des fibres et/ou d'une matière plastique composite à fibres, **caractérisé en ce que** le châssis de base comprend une plaque massive (1) constituée d'une matière plastique composite à fibres et **en ce que** chaque plaque (1) du châssis de base ou le châssis de base est constitué de plusieurs éléments plats en forme de plaques reliés entre eux, de préférence sous la forme d'une structure de type sandwich.

2. Dispositif selon la revendication 1, **caractérisé en ce que** le dispositif comprend un module d'usinage (2) qui supporte l'outil (6) et qui est logé de manière coulissante le long d'un trajet, de préférence linéaire.

3. Dispositif selon la revendication 2, **caractérisé en ce que** le trajet le long duquel le module d'usinage (2) est logé de manière coulissante est disposé horizontalement en position de travail.

4. Dispositif selon la revendication 1, **caractérisé en ce que** le châssis de base présente une forme de C et est constitué d'une matière plastique ou d'un composite de matières plastiques à fibres, au moins évidement étant réalisé dans le châssis de base, qui est traversé par l'outil (6), qui coulisse dans cet évidement le long du trajet et une extrémité du trajet se trouve à l'intérieur du châssis de base en forme de C.

5. Dispositif selon l'une des revendications précédentes, **caractérisé en ce que** le module d'usinage (2) est constitué au moins partiellement d'une matière plastique renforcée à l'aide de fibres ou d'un composite de matières plastiques à fibres.

6. Dispositif selon l'une des revendications précédentes, **caractérisé en ce que** le module d'usinage (2) et/ou le châssis de base est constitué entièrement d'une matière plastique renforcée à l'aide de fibres ou d'un composite de matières plastiques à fibres.

7. Dispositif selon l'une des revendications précédentes, **caractérisé en ce que** le module d'usinage (2) comprend au moins une plaque massive (1) en composite de matières plastiques à fibres.

8. Dispositif selon la revendication 7, **caractérisé en ce que** la plaque du module d'usinage (2) est orientée parallèlement par rapport à la plaque (1') du châssis de base.

9. Dispositif selon la revendication 7 ou 8, **caractérisé en ce que** chaque plaque (1) et/ou le module d'usinage (2) est constitué de plusieurs éléments plats en forme de plaques reliés entre eux, de préférence sous la forme d'une structure de type sandwich.

10. Dispositif selon l'une des revendications précédentes, **caractérisé en ce que** le composite de matières plastiques à fibres comprend une matrice thermoplastique ou thermodurcissable, de préférence en résine époxy.

11. Dispositif selon l'une des revendications précédentes, **caractérisé en ce que** le composite de matières plastiques à fibres contient des fibres de renfort anorganiques et/ou des fibres de renfort organiques, plus particulièrement des fibres de carbone.

12. Dispositif selon l'une des revendications précédentes, **caractérisé en ce que** les fibres se présentent sous la forme de rovings, de fibres courtes, de nattes, de tissus ou de canevas.

13. Dispositif selon l'une des revendications précédentes, **caractérisé en ce que** le composite de matières plastiques à fibres est une matière plastique renforcée à l'aide de fibres de carbone, les fibres étant intégrées dans la matrice de matière plastique de préférence sur plusieurs couches et le module d'élasticité des fibres étant supérieur au module d'élasticité de la matrice de matière plastique.

14. Dispositif selon l'une des revendications précédentes, **caractérisé en ce que** le composite de matières plastiques à fibres contient des fibres courtes d'une longueur entre 0,1 et 5 mm et/ou des fibres longues d'une longueur entre 80% et 150% de la dimension maximale du châssis de base ou du module d'usinage et/ou des fibres sans fin et/ou **en ce que** le composite de matières plastiques à fibres présente une teneur en fibres de 40 à 80% en poids.

15. Dispositif selon l'une des revendications précédentes, **caractérisé en ce que** le module d'usinage (2) comprend une pluralité d'évidements dans lesquels les outils (6) sont insérés et/ou **en ce que** le dispositif comprend des outils pour le poinçonnage, le pliage, l'estampage, le rivetage ou le pressage.
